# EUROPEAN PATENT APPLICATION

(11) **EP 3 273 467 A2**
(43) Date of publication of application: **24.01.2018**
(21) Application number: 17175835.2
(22) Date of filing: 13.06.2017
(51) Int. Cl.: H01L 21/60, H01L 23/522

(54) **SEMICONDUCTOR DIE BACKSIDE DEVICES AND METHODS OF FABRICATION THEREOF**

(30) Priority: 28.06.2016 US 201615194775
(71) Applicant: General Electric Company, Schenectady, NY 12345 (US)
(72) Inventor: GOWDA, Arun Virupaksha, Niskayuna, OR 12309 (US); TUOMINEN, Risto llkka, Niskayuna, NY 12309 (US)
(74) Representative: Cleary, Fidelma

(57) **Abstract**

A die (102) for a semiconductor chip package includes a first surface (104) including an integrated circuit (106) formed therein. The die also includes a backside surface (108) opposite the first surface. The backside surface has a total surface area (206) defining a substantially planar region (302) of the backside surface. The die further includes at least one device (132) formed on the backside surface. The at least one device includes at least one extension (136) extending from the at least one device beyond the total surface area.

## Description

### BACKGROUND

The field of the disclosure relates generally to packaged semiconductor chip devices, and, more specifically, to semiconductor die backside devices and methods of fabrication thereof

In known semiconductor chips, the backside surface of a semiconductor die of a semiconductor chip package is typically non-functional and is used for only mechanical and thermal purposes. Underutilization of backside die surfaces in such known semiconductor chip packages represents a limitation on continued improvement in the trend of enhanced functionality, performance, and miniaturization in the microelectronics industry. Also, in such known semiconductor chip packages, added functionality will continue to be added at the wafer level, but in many applications, wafer level improvements will not be practical without substantially increasing die size, wafer cost, and package size.

In at least some known semiconductor chip packages, a separate, i.e., non-integrated, discrete device is embedded alongside the semiconductor device that is being packaged. Adding functionality at the wafer level, however, also takes up space and increases the volume of the package, thereby leading to a reduced functionality per unit volume. Such separate and discrete devices, e.g., at least one of various types of sensors, passive circuit elements, and active circuit elements embedded alongside semiconductor chip packages or integrated at the wafer level, are functionally desirable. Although such separate and discrete devices are being fabricated with decreasing sizes in at least some known semiconductor chip packages, they still increase package volume due to lower limits on die thickness required to receive and maintain integrated circuits therein. Thus, in such known semiconductor chip packages, a significant limitation to further miniaturization while maintaining or increasing performance and functionality exists. Furthermore, in at least some known semiconductor chip packages, the aforementioned desired trend is further limited by the fact that although integration of discrete sensors and elements is possible at the semiconductor die wafer level, not all devices can be integrated at the wafer and die level using currently existing methods of manufacture.

### BRIEF DESCRIPTION

In one aspect, a die for a semiconductor chip package is provided. The die includes a first surface including an integrated circuit formed therein. The die also includes a backside surface opposite the first surface. The die further includes at least one device coupled to the backside surface. The backside surface has a total surface area defining a substantially planar region of the backside surface. The die further includes at least one device formed on the backside surface. The at least one device includes at least one extension extending from the at least one device beyond the total surface area.

In another aspect, a semiconductor chip package is provided. The semiconductor chip package includes at least one dielectric layer and at least one metallized layer coupled to the at least one dielectric layer. The semiconductor chip package also includes at least one die coupled to at least one of the at least one dielectric layer and the at least one metallized layer. The die includes a first surface including an integrated circuit formed therein. The die also includes a backside surface opposite the first surface. The die further includes at least one device coupled to the backside surface. The backside surface has a total surface area defining a substantially planar region of the backside surface. The die further includes at least one device formed on the backside surface. The at least one device includes at least one extension extending from the at least one device beyond the total surface area.

In still another aspect, a method of manufacturing a semiconductor chip package is provided. The semiconductor chip package includes at least one dielectric layer. The method includes coupling at least one die to the at least one dielectric layer. The at least one die includes a first surface including an integrated circuit formed therein. The at least one die also includes a backside surface opposite the first surface, the backside surface having a total surface area defining a substantially planar region of said backside surface. The method also includes fabricating at least one device on the backside surface, the at least one device including at least one extension extending from the at least one device beyond the total surface area.

### DRAWINGS

These and other features, aspects, and advantages of the present disclosure will become better understood when the following detailed description is read with reference to the accompanying drawings in which like characters represent like parts throughout the drawings, wherein:
FIG. 1 is a cross-sectional schematic view of an exemplary semiconductor chip package;
FIG. 2 is a schematic diagram of an exemplary backside surface of a die that may be used with the semiconductor chip package shown in FIG. 1;
FIG. 3 is a perspective diagram of an exemplary die that may be used with the semiconductor chip package shown in FIG. 1;
FIG. 4 is a schematic diagram of an exemplary sequence that may be used to manufacture the semiconductor chip package shown in FIG. 1; and
FIG. 5 is a flowchart of an exemplary method of manufacturing a semiconductor chip package that may be used to manufacture the semiconductor chip package shown in FIG. 1.

Unless otherwise indicated, the drawings provided herein are meant to illustrate features of embodiments of this disclosure. These features are believed to be applicable in a wide variety of systems comprising one or more embodiments of this disclosure. As such, the drawings are not meant to include all conventional features known by those of ordinary skill in the art to be required for the practice of the embodiments disclosed herein.

### DETAILED DESCRIPTION

In the following specification and the claims, reference will be made to a number of terms, which shall be defined to have the following meanings.

The singular forms "a", "an", and "the" include plural references unless the context clearly dictates otherwise.

"Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately", and "substantially", are not to be limited to the precise value specified. In at least some instances, the approximating language may correspond to the precision of an instrument for measuring the value. Here and throughout the specification and claims, range limitations may be combined and/or interchanged, and such ranges are identified and include all the sub-ranges contained therein unless context or language indicates otherwise.

The semiconductor die backside devices and methods of fabrication thereof described herein provide functionality to the backside surface of the die, either by themselves or in addition to an integrated circuit therein. The embodiments described herein also facilitate mitigating limitations on increasing functionality, performance, and miniaturization of microelectronics. The embodiments described herein are further suited to improving functionality, performance, and miniaturization of microelectronics at other than the wafer lever of semiconductor dies. The semiconductor die backside devices and methods of fabrication thereof described herein are also suited to reducing the size and increasing the functionality per unit volume of semiconductor chip packages with devices added to the backside surface of the die. The embodiments described herein are further suited to providing manufacturing methods for adding devices to die backside surfaces in semiconductor chip packages that otherwise are unable to be integrated at the die level.

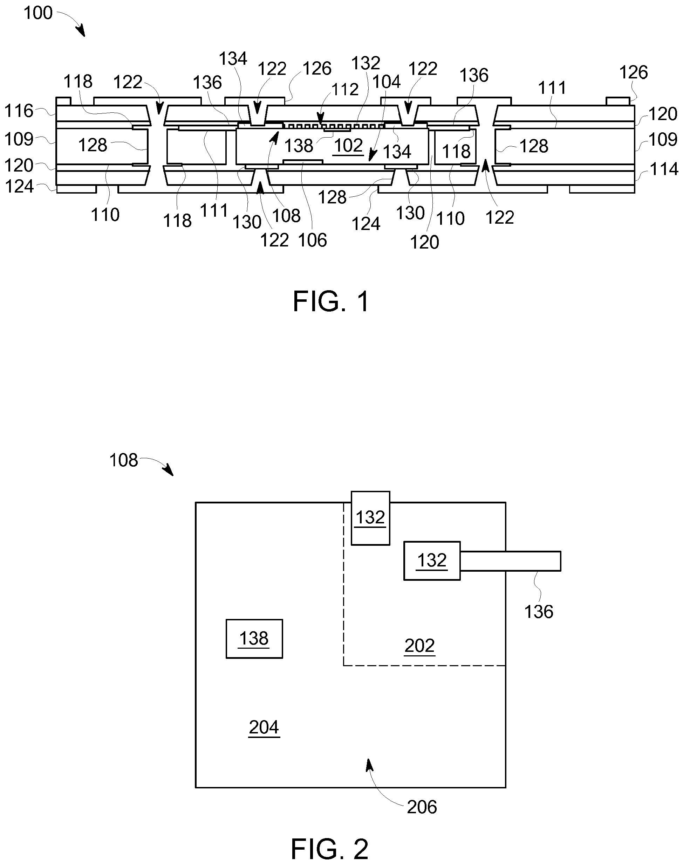

FIG. 1 is a cross-sectional schematic view of an exemplary semiconductor chip package 100. In the exemplary embodiment, semiconductor chip package 100 includes a die 102, e.g., a silicon semiconductor die formed from a semiconductor wafer disk. Die 102 includes a first surface 104 and at least one integrated circuit 106 formed in at least a portion of first surface 104. Die 102 also includes a backside surface 108 opposite first surface 104. Die 102 further includes a first physical characteristic including, without limitation, a thickness, a length, a width, a surface area, a material, a rigidity, types of materials used for die 102, and a purity thereof. Integrated circuit 106 includes a second physical characteristic including, without limitation, a number of integrated circuits 106 formed in first surface 104, a depth into which integrated circuit 106 is formed into first surface 104, a percentage of first surface 104 in which integrated circuit 106 is formed, a type of integrated circuit 106, and types of materials used for integrated circuit 106.

Also, semiconductor chip package 100 includes at least one dielectric layer formed as a substantially planar layer. Dielectric layer includes a core dielectric layer 109 including a first side 110 and a second side 111 opposite first side 110. In the exemplary embodiment, core dielectric layer 109 also includes an aperture 112 defined through core dielectric layer 109. Further, in semiconductor chip package 100, die 102 is positioned in aperture 112. Semiconductor chip package 100 also includes at least one first dielectric layer 114, e.g., a first dielectric layer formed as a substantially planar layer. First dielectric layer 114 is positioned proximate first side 110 of core dielectric layer 109. Semiconductor chip package 100 also includes at least one second dielectric layer 116, e.g., a second dielectric layer formed as a substantially planar layer having a finite thickness and a surface area substantially the same as the surface area of core dielectric layer 109. Second dielectric layer 116 is positioned proximate second side 111 of core dielectric layer 109. In other embodiments, not shown, semiconductor chip package 100 does not include at least one of core dielectric layer 109, aperture 112, and second dielectric layer 116. Rather, in such other embodiments, die 102 is coupled to first dielectric layer 114 only.

Further, semiconductor chip package 100 includes at least one conductive core 118 positioned on, including coupled to, at least one of first side 110 and second side 111 of core dielectric layer 109. Conductive core 118 is formed of a conductive material including, without limitation, copper metal. Semiconductor chip package 100 also includes at least one adhesive layer 120. Adhesive layer 120 is positioned between first dielectric layer 114 and first side 110 of core dielectric layer 109. Adhesive layer 120 is further positioned between second dielectric layer 116 and second side 111 of core dielectric layer 109. Adhesive layer 120 also extends into a remaining space of aperture 112 between core dielectric layer 109 and die 102. Adhesive layer 120 couples together at least one of first dielectric layer 114, second dielectric layer 116, core dielectric layer 109, die 102, and conductive core 118. In other embodiments, not shown, semiconductor chip package 100 does not include conductive core 118, but rather at least two portions of semiconductor chip package 100 are independently addressed and, thus, need not communicate with one another. In still other embodiments, not shown, semiconductor chip package 100 does not include adhesive layer 120, but rather includes at least one film layer, not shown, including, without limitation, a heat-flowable film, that functions to couple together at least one of core dielectric layer 109, first dielectric layer 114, second dielectric layer 116, conductive core 118, and die 102.

Furthermore, semiconductor chip package 100 includes at least one via 122 defined through at least one of core dielectric layer 109, first dielectric layer 114, second dielectric layer 116, and adhesive layer 120 (if present). Also, in the exemplary embodiment, via 122 is formed of a conductive material including, without limitation, copper metal. In other embodiments, not shown, via 122 is formed of a non-conductive material including, without limitation, a material enabling optical sensing and communication. In still other embodiments, not shown, via 122 includes both a conductive material and a non-conductive material, including, without limitation, at least two layers formed of differing materials, e.g., a multi-purpose via enabling a combination of electrical coupling and at least one of sensing and communication, including, without limitation, optical sensing and communication. In other embodiments, not shown, via 122 is not formed of at least one of a conductive material and a non-conductive material, but rather via 122 is a defined as a cavity, e.g., a through-hole, through at least one of core dielectric layer 109, first dielectric layer 114, second dielectric layer 116, and adhesive layer 120.

Moreover, in the exemplary embodiment, semiconductor chip package 100 also includes at least one metallized layer including a first metallized layer 124 coupled to first dielectric layer 114, and a second metallized layer 126 coupled to second dielectric layer 116. First metallized layer 124 and second metallized layer 126 are formed of a conductive material including, without limitation, copper metal. Also, in the exemplary embodiment, semiconductor chip package 100 includes at least one interconnect 128 coupled to at least one of first metallized layer 124 and second metallized layer 126. Interconnect 128 is formed of a conductive material including, without limitation, copper metal. In other embodiments, not shown, interconnect 128 is formed of at least one of a non-conductive material and a combination of conductive and non-conductive materials including, without limitation, an interconnect 128 enabling data transmission through optical waveguides. In still other embodiments, not shown, semiconductor chip package 100 does not include interconnect 128, but rather at least two portions of semiconductor chip package 100 are independently addressed and, thus, need not communicate with one another. In yet other embodiments, not shown, interconnect 128 is formed of a non-conductive material including, without limitation, a material enabling optical sensing and communication. In still other embodiments, not shown, interconnect 128 includes both a conductive material and a non-conductive material, including, without limitation, at least two layers formed of differing materials, e.g., a multi-purpose via enabling a combination of electrical coupling and at least one of sensing and communication, including, without limitation, optical sensing and communication. In still other embodiments, not shown, interconnect 128 includes both a conductive material and a non-conductive material, including, without limitation, at least two layers formed of differing materials, e.g., a multi-purpose interconnect enabling a combination of electrical coupling and at least one of sensing and communicative, including, without limitation, optical sensing and communication.

Also, in the exemplary embodiment, interconnect 128 extends through via 122 to enable coupling together of at least one of first metallized layer 124, second metallized layer 126, and conductive core 118. Further, in the exemplary embodiment, semiconductor chip package 100 includes at least one first surface pad 130 coupled to first surface 104 of die 102. First surface pad 130 is further coupled to at least one via 122. In other embodiments, not shown, first surface pad 130 is also coupled to integrated circuit 106.

Further, in the exemplary embodiment, semiconductor chip package 100 includes at least one device 132 formed on, including coupled to, backside surface 108 of die 102. In the exemplary embodiment, device 132 is embodied in a non-integrated circuit-type device. In other embodiments, not shown, device 132 is embodied in a non-semiconductor-type device. Furthermore, in the exemplary embodiment, device 132 includes, without limitation, at least one of a sensor-type device, an active circuit element-type device, and a passive circuit element-type device. Device 132 has a third physical characteristic including, without limitation, a number of devices 132 formed on backside surface 108, a distance to which device 132 extends beyond backside surface 108, a percentage of backside surface 108 upon which device 132 is coupled, a type of device 132, and types of materials used for device 132. Moreover, in the exemplary embodiment, device 132 is formed of at least one of a conductive material, a non-conductive material, and a semiconductor material. Also, in the exemplary embodiment, semiconductor chip package 100 includes at least one second surface pad 134 coupled to backside surface 108 of die 102. Second surface pad 134 is further coupled to at least one via 122. Also, in the exemplary embodiment, second surface pad 134 is further coupled to device 132. In other embodiments, not shown, second surface pad 134 is not coupled to at least one of device 132 and via 122. In still other embodiments, not shown, semiconductor chip package 100 does not include second surface pad 134.

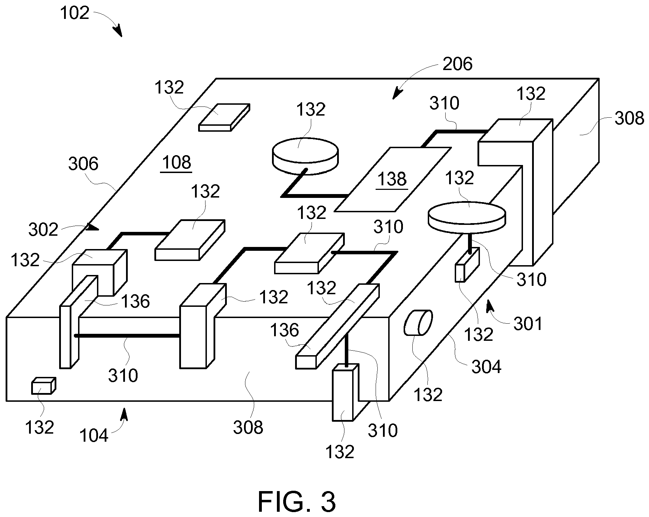

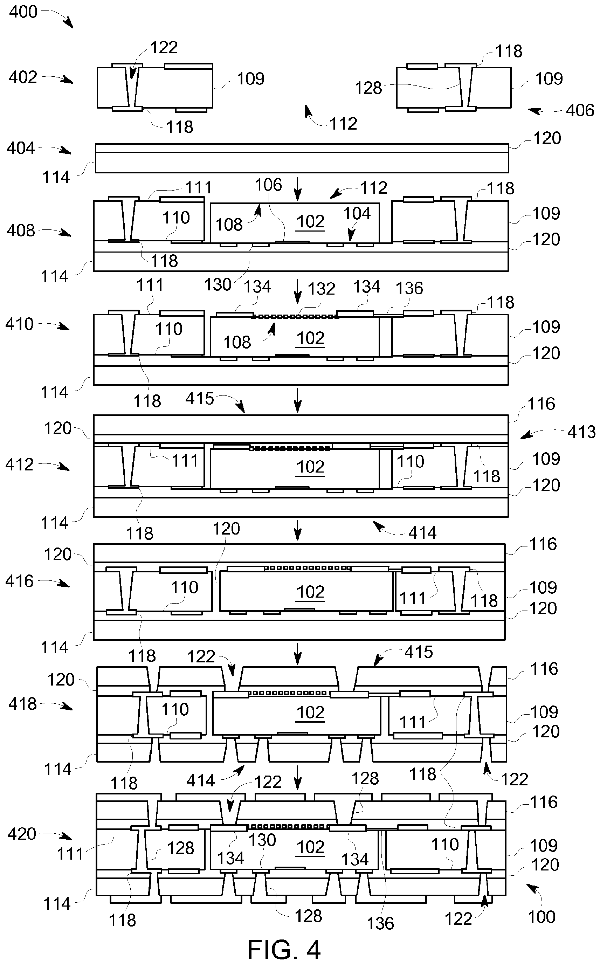

Further, in the exemplary embodiment, semiconductor chip package 100 includes at least one extension 136 at least one of formed on, formed within, and coupled to at least one of device 132, die 102, and second surface pad 134. Extension 136 is further coupled to at least one of core dielectric layer 109, conductive core 118, and interconnect 128. In other embodiments, not shown, extension 136 is formed as an integral part of, rather than coupled to device 132. In still other embodiments, not shown, at least one device 132 includes a plurality of devices 132, where at least one extension 136 is formed as an integral part of at least one device 132 of the plurality of devices 132, and at least one device 132 of the plurality of devices 132 does not include extension 136. In yet other embodiments, not shown, at least two devices 132 of the plurality of devices 132 are at least one of electrically and communicatively coupled together. In the exemplary embodiment, extension 136 is formed of a conductive material including, without limitation, copper metal. In other embodiments, not shown, extension 136 is formed of at least one of a semiconducting material and a non-conductive material including, without limitation, a material enabling data transmission through fiber-optic communication. In still other embodiments, not shown, extension 136 includes both a conductive material and a non-conductive material, e.g., a multi-purpose extension enabling a combination of electrical coupling and communicative coupling, including, without limitation, fiber-optic data transmission and receipt. In yet other embodiments, not shown, semiconductor chip package 100 does not include extension 136. Furthermore, in the exemplary embodiment, extension 136 enables device 132 to project beyond a surface area of backside surface 108 of die 102 and thus, not be confined thereto. Additional details regarding forming at least one device 132 on backside surface 108 of die 102 and coupling at least one extension 136 to at least one of device 132, die 102, and second surface pad 134 are shown and described below with reference to FIGs. 3 and 4.

Furthermore, in the exemplary embodiment, semiconductor chip package 100 includes at least one additional integrated circuit 138 formed in at least a portion of backside surface 108 of die 102. In other embodiments, not shown, semiconductor chip package 100 does not include additional integrated circuit 138. Moreover, in the exemplary embodiment, additional integrated circuit 138 is coupled to device 132 and second surface pad 134. In other embodiments, not shown, additional integrated circuit 138 is not coupled to at least one of device 132 and second surface pad 134. Also, in the exemplary embodiment, additional integrated circuit 138 is electrically and communicatively isolated from integrated circuit 106. In other embodiments, not shown, additional integrated circuit 138 is at least one of electrically coupled and communicatively coupled to integrated circuit 106. Also, in the exemplary embodiment, integrated circuit 106 is electrically and communicatively isolated from at least one of device 132, additional integrated circuit 138, and second surface pad 134. In other embodiments, not shown, integrated circuit 106 is at least one of electrically coupled and communicatively coupled to at least one of device 132, additional integrated circuit 138, and second surface pad 134.

In operation, in semiconductor chip package 100, integrated circuit 106 formed in first surface 104 and additional integrated circuit 138, if present, formed in backside surface 108 both contain microelectronic devices including, without limitation, transistor devices, which function as at least one of circuit elements, memory elements, and processing units for carrying out computerized operations. Integrated circuit 106 and additional integrated circuit 138 require electrical power from a power source (not shown). Integrated circuit 106 and additional integrated circuit 138 also require communication lines including, without limitation, at least one of electrical communication lines and optical communication lines, between at least one of microelectronic devices within singular instances of integrated circuit 106, microelectronic devices within singular instances of additional integrated circuit 138, microelectronic devices between a plurality of integrated circuits 106 within one semiconductor chip package 100, microelectronic devices between a plurality of additional integrated circuits 138 within one semiconductor chip package 100, and microelectronic devices between a plurality of semiconductor chip packages 100. At least one of electrical power lines and communication lines interact with integrated circuit 106 through first surface pad 130. At least one of electrical power lines and communication lines interact with additional integrated circuit 138 through second surface pad 134. From first surface pad 130 and second surface pad 134, at least one of electrical power connections and communication connections are made with other devices of at least one of a single semiconductor chip package 100 and other semiconductor chip packages 100 through at least one of via 122, conductive core 118, interconnect 128, first metallized layer 124, and second metallized layer 126.

Also, in operation of semiconductor chip package 100, core dielectric layer 109, first dielectric layer 114, and second dielectric layer 116 provide structural support and protection for semiconductor chip package 100. Die 102 with integrated circuit 106 is positioned within aperture 112 and is surrounded by, and thus supported and protected by core dielectric layer 109, first dielectric layer 114, and second dielectric layer 116. Further, in operation of semiconductor chip package 100, core dielectric layer 109, first dielectric layer 114, and second dielectric layer 116 provide electrical insulation and electrical isolation between electrically conductive devices and components of semiconductor chip package 100 including, without limitation, integrated circuit 106, additional integrated circuit 138, device 132, extension 136, first surface pad 130, second surface pad 134, via 122, conductive core 118, interconnect 128, first metallized layer 124, and second metallized layer 126. Moreover, in operation of semiconductor chip package 100, core dielectric layer 109, first dielectric layer 114, and second dielectric layer 116 provide electrical insulation and electrical isolation between electrically conductive devices and components of semiconductor chip package 100 and other semiconductor conductor chip packages 100 in systems and devices having a plurality of semiconductor chip packages 100.

Further, in operation of semiconductor chip package 100, die 102 has a first physical characteristic and integrated circuit 106 formed in first surface 104 of die 102 has a second physical characteristic. For example, in operation of semiconductor chip package 100, a lower limit on thickness of die 102 provides a first upper limit on depth into which integrated circuit 106 is formable in first surface 104 of die 102. Additionally, for example, the first upper limit on depth into which integrated circuit 106 is formed in first surface 104 of die 102 provides a second upper limit on depth into which additional integrated circuit 138 is formable in backside surface 108 of die 102. Furthermore, in operation of semiconductor chip package 100, at least one device 132 is formed on backside surface 108 rather than formed therein like additional integrated circuit 138 (as further described below with reference to FIGs. 3 and 4). As such, coupling device 132 to backside surface 108 of die 102 enables addition of functional components including, without limitation, additional microelectronic components, to semiconductor chip package 100 without such addition of functional components being constrained in the same manner as limits imposed by the first physical characteristic of die 102 and second physical characteristic of integrated circuit 106. Thus, in operation of the exemplary embodiment, device 132 including the third physical characteristic is formed on backside surface 108 of die 102 to provide additional functional components to semiconductor chip package 100 without being subject to the same limitations that first physical characteristic and second physical characteristic impose on one another.

Furthermore, in operation of semiconductor chip package 100, at least one device 132 includes a wide variety of devices able to be formed on backside surface 108 of die 102. Device 132 includes passive circuit elements including, without limitation, microelectronic passive circuit elements, such as resistors, inductors, and radio-frequency identification (RFID) devices. For example, in a system including at least a first semiconductor chip package 100 and a second semiconductor chip package 100, where both first and second semiconductor chip packages 100 include a die 102 of the same type (i.e., having the same first physical characteristic), a first resistor-type device 132 having a first resistance value is coupled to first semiconductor chip package 100 and a second resistor-type device 132 having a second resistance value different from the first resistance value is coupled to second semiconductor chip package 100. Thus, two semiconductor chip packages 100 having different resistance values are incorporated into the system without requiring at least one of changing die 102, changing integrated circuit 106 on backside surface 108, and changing additional integrated circuit 138 on backside surface 108 of die 102. Similarly, device 132 includes active circuit elements including, without limitation, microelectronic active circuit elements, such as diodes, transistors, battery cells, piezoelectric devices, optoelectronic devices, and micro-electro-mechanical systems (MEMS) devices, providing substantially the same aforementioned advantages as passive circuit element devices 132 including customizability and versatility, i.e., at the semiconductor chip package 100 level rather than merely at the wafer level of die 102. For example, at least one of one or more active circuit element devices 132 and one or more passive circuit element devices 132 generate heat to at least one of modulate a temperature of one or more semiconductor chip packages 100 in a system subject to extreme temperature fluctuations and provide a source of electrical energy to facilitate increasing the operating voltage of one or more semiconductor chip packages 100.

Moreover, in operation of semiconductor chip package 100, device 132 includes a wide variety of sensor devices including, without limitation, thin film-type sensors, gas sensors, temperature sensors, strain sensors, stress sensors, and combinations thereof. For example, sensor devices 132 facilitate providing information to users of semiconductor chip package 100 about conditions therein and obviate the need to disassemble semiconductor chip package 100 obtain such information. Further, for example, a gas sensor device 132 is positioned proximate a via 122 defined as a cavity, i.e., a through-hole rather than a filled via 122 (as described above), exposed to an gaseous environment on an exterior of semiconductor chip 100 and is operable to at least one of sense, measure, and report a composition of the gaseous environment. Similarly, for example, a sensor device 132 is positioned proximate via 122 filled with a material enabling sensing of the immediate environment proximate via 122. Also, for example, sensor devices 132 are coupled to at least one of a processor, a computer-readable memory, and a human machine interface (HMI) display to enable users of semiconductor chip package 100 to store, read, track, and analyze such information including, without limitation, in real time.

Also, for example, information gathered and provided by sensor devices 132 about conditions at least one of inside or outside semiconductor chip package 100 provides users thereof with diagnostic functionality, e.g., for maintenance activities. For example, at least one of a strain sensor device 132, a stress sensor device 132, and a temperature sensor device 132 of one or more semiconductor chip packages 100 in a system indicates which semiconductor chip package 100 of the system is experiencing at least one of a strain condition, a stress condition, and a temperature condition thereof indicative of imminent failure. As such, users of the system replace only affected semiconductor chip packages 100 rather than the entire system, thereby reducing operating and maintenance costs, and extending system service lifetime. Further, for example, device 132 includes a radio frequency identification (RFID) device configured to transmit electromagnetic radiation including, without limitation, a radio wave at a particular frequency. RFID-type device 132 enables a user of semiconductor chip package 100 to find and uniquely identify individual semiconductor chip packages 100 including, without limitation, in a system including a plurality of semiconductor chip packages 100. RFID-type device 132 also facilitates inclusion of anti-counterfeiting measures in semiconductor chip package 100.

FIG. 2 is a schematic diagram of an exemplary backside surface 108 of die 102 that may be used with the semiconductor chip package 100 shown in FIG. 1. In the exemplary embodiment, backside surface 108 of die 102 includes a first surface area 202 and a second surface area 204. A value of first surface area 202 of backside surface 108 and a value of second surface area 204 of backside surface 108 sum to a total surface area 206 of backside surface 108. First surface area 202 includes at least one first fractional portion of total surface area 206 and second surface area 204 includes at least one second fractional portion of total surface area 206. Also, in the exemplary embodiment, at least one device 132 is formed on to at least a portion of first surface area 202 including, without limitation, to more than one first fractional portion of total surface area 206. Further, in the exemplary embodiment, at least one additional integrated circuit 138 is formed in at least a portion of second surface area 204 including, without limitation, to more than one second fractional portion of total surface area 206. In other embodiments, not shown, at least one device 132 is formed on at least portions of both first surface area 202 and second surface area 204, and at least one additional integrated circuit 138 is formed in at least portions of both first surface area 202 and second surface area 204.

Also, in the exemplary embodiment, extension 136 is coupled to device 132 and extends beyond an extent, i.e., boundary, of total surface area 206, i.e., to further couple device 132 to at least one of core dielectric layer 109, conductive core 118, and interconnect 128, additional dies 102, and any other suitable devices, components, interfaces, layers, and materials, not shown in FIG. 2, as shown and described above with reference to FIG. 1. In other embodiments, not shown, at least one device 132 includes a plurality of devices 132, where at least one extension 136 is formed as an integral part of at least one device 132 of the plurality of devices 132, and at least one device 132 of the plurality of devices 132 does not include extension 136. In still other embodiments, not shown, at least two devices 132 of the plurality of devices 132 are at least one of electrically and communicatively coupled together. Further, in the exemplary embodiment, device 132 extends beyond boundary of total surface area 206 of backside surface 108.

In operation, in the exemplary embodiment, integrated circuit 106 (not shown) is fabricated in first surface 104 of die 102 at the wafer level prior to packaging semiconductor chip package 100. A wafer (not shown) having a plurality of integrated circuits 106 fabricated therein is then diced (i.e., singulated) into a plurality of individual dies 102, where first surface 104 each die 102 of the plurality of dies 102 includes at least one integrated circuit 106. After singulation of the wafer, packaging of semiconductor chip package 100 proceeds as described below with reference to FIG. 4. With individual dies 102 assembled onto and coupled to core dielectric layers 109 (e.g., as packaging substrates) of individual semiconductor chip package 100, at least one discrete device 132 is formed on backside surface 108. Also, in operation of the exemplary embodiment, additional integrated circuit 138 is formed in backside surface 108 after die 102 is assembled onto and coupled to core dielectric layer 109, as shown and described below with reference to FIG. 4. In other embodiments, not shown, additional integrated circuit 138 is formed in backside surface 108 at least one of before singulation and after singulation but prior to coupling die 102 to core dielectric layer 109. Further, in operation of the exemplary embodiment, at least one of electrical coupling and communication coupling of at least one of device 132 and extension 136 to complete packaging of semiconductor chip package 100 takes place after fabrication of at least one of device 132 and extension 136 on backside surface 108.

FIG. 3 is a perspective diagram of an exemplary die 102 that may be used with semiconductor chip package 100 shown in FIG. 1. In the exemplary embodiment, backside surface 108 includes at least one device 132 formed thereon and at least one additional integrated circuit 138 formed therein. In other embodiments, not shown, backside surface 108 does not include additional integrated circuit 138. Also, in the exemplary embodiment, die 102 includes first surface 104 opposite backside surface 108. First surface 104 defines a first substantially planar region 301 having a surface area substantially equal to total surface area 206 of backside surface 108. In other embodiments, not shown, first substantially planar region 301 of first surface 104 is not substantially equal to total surface area 206. Backside surface 108 likewise defines a second substantially planar region 302 having total surface area 206. Further, in the exemplary embodiment, a boundary of first surface 104 includes a first edge 304 defining a perimeter of first surface 104. Similarly, a boundary of total surface area 206 of backside surface 108 includes a second edge 306 defining a perimeter of backside surface 108.

Also, in the exemplary embodiment, die 102 includes a sidewall 308 extending between first edge 304 and second edge 306. Further, in the exemplary embodiment, at least one device 132 is formed on backside surface 108. Device 132 includes extension 136 extending beyond the boundary of total surface area 206 of backside surface 108. Further, in the exemplary embodiment, extension 136 further extends from discrete device 132 onto sidewall 308 and is formed on sidewall 308. In other embodiments, not shown, extension 136 further extends from sidewall 308 to first surface 104. Furthermore, in the exemplary embodiment, at least one discrete device 132 if formed on sidewall 308. Discrete device 132 formed on sidewall 308 extends from sidewall onto at least one of backside surface 108 and first surface 104. Moreover, in the exemplary embodiment, at least two discrete devices 132 are coupled to one another through at least one connection line 310 formed on at least one of backside surface 108, sidewall 308, and first surface 104. Also, in the exemplary embodiment, at least one discrete device 132 is coupled to at least one of additional integrated circuit 138 and integrated circuit 106, not shown. Connection line 310 is embodied in at least one of an electrical line and a communication line, and is formed of at least one of a conductive material and a non-conductive material. Connection line 310 is further embodied in at least one of a connection line 310 formed on at least one of backside surface 108, sidewall 308, and first surface 104, e.g., in a manner similar to forming device 132 on backside surface 108, and a connection line 310 formed in at least one of backside surface 108, sidewall 308, and first surface 104, e.g., in a manner similar to forming additional integrated circuit 138 in backside surface 108.

FIG. 4 is a schematic diagram of an exemplary sequence 400 that may be used to manufacture semiconductor chip package 100 shown in FIG. 1. In the exemplary embodiment, sequence 400 begins with a first metallizing 402 step. First metallizing 402 includes positioning, including coupling, conductive core 118 to at least one of first side 110 and second side 111 of core dielectric layer 109. Also, in the exemplary embodiment, aperture 112 is defined in core dielectric layer 109 prior to first metallizing 402. In other embodiments, not shown, aperture 112 is defined in core dielectric layer at least one of during and after first metallizing 402. In still other embodiments, not shown, sequence 400 does not include defining aperture 112 in core dielectric layer 109. In yet other embodiments, not shown, semiconductor chip package 100 does not include core dielectric layer 109, and first metallizing 402 step including, without limitation, at least one of the sub-steps thereof described herein, is performed on at least one of first dielectric layer 114 and second dielectric layer 116. Further, in the exemplary embodiment, at least one via 122 is defined, e.g., drilled, through core dielectric layer 109 during first metallizing 402. In other embodiments, not shown, at least one via 122 is defined through core dielectric layer 109 before first metallizing 402. In still other embodiments, not shown, at least one via 122 is defined through core dielectric layer 109 after first metallizing 402. In still other embodiments, first metallizing 402 does not include defining at least one via 122 through core dielectric layer 109.

Also, in the exemplary embodiment, first metallizing 402 includes removing by processes including, without limitation, etching, masking, cutting, dissolving, heating, and combinations thereof, at least a portion of conductive core 118 from at least one of first side 110 and second side 111 of core dielectric layer 109, to create patterns of at least one of electrical power lines and communication lines in conductive core 118, i.e., patterning. First metallizing 402 further includes forming at least one interconnect 128 through at least one via 122 defined in core dielectric layer 109. In other embodiments, not shown, first metallizing 402 does not include at least one of patterning and forming sub-steps.

Further, in the exemplary embodiment, sequence 400 proceeds from first metallizing 402 to a preparing 404 step. Preparing 404 includes positioning a first adhesive layer 120 including, without limitation, b-staged adhesive, upon one side of first dielectric layer 114. In other embodiments, not shown, preparing 404 includes positioning first adhesive layer 120 upon first side 110 of core dielectric layer 109, rather than positioning first adhesive layer 120 upon one side of first dielectric layer 114. In still other embodiments, not shown, preparing 404 does not include positioning first adhesive layer 120 upon one side of first dielectric layer 114, but rather preparing 404 includes placement of at least one film layer, not shown, including, without limitation, a heat-flowable film imparting adhesive properties upon heating, upon one side of first dielectric layer 114. Preparing 404 thus results in a frame 406 including first side 110 of core dielectric layer 109 positioned proximate to and substantially aligned with adhesive layer 120 of one side of first dielectric layer 114. In other embodiments, not shown, preparing 404 results in frame 406 including first side 110 of core dielectric layer 109 positioned proximate to and substantially aligned with first dielectric layer 114.

Furthermore, in the exemplary embodiment, sequence 400 proceeds from preparing 404 to a positioning 408 step. Positioning 408 includes placement of first side 110 of core dielectric layer 109 into first adhesive layer 120 to couple first side 110 to first dielectric layer 114. In other embodiments, not shown, positioning 408 includes placement of first dielectric layer 114 into first adhesive layer 120 on first side 110. Positioning 408 also includes placing die 102 into first adhesive layer 120 on first dielectric layer 114 through aperture 112 of core dielectric layer 109. Upon commencing position 408, die 102 includes at least one integrated circuit 106 formed in first surface 104 of die 102. In other embodiments, not shown, positioning 408 includes adding additional adhesive to first adhesive layer 120 through aperture 112 prior to placing die 102 into first adhesive layer 120 through aperture 112. In still other embodiments, not shown, semiconductor chip package 100 does not include at least one of core dielectric layer 109 and aperture 112, and positioning 408 does not include placement of first side 110 into first adhesive layer 120. Moreover, in the exemplary embodiment, prior to positioning 408 step, integrated circuit 106 is formed in first surface 104 of die 102. Similarly, prior to positioning 408 step, first surface pad 130 is coupled to first surface 104 of die 102.

Moreover, in the exemplary embodiment, sequence 400 proceeds from positioning 408 to a fabricating 410 step. Fabricating 410 includes at least one of forming and coupling at least one device 132 on backside surface 108 of die 102. Fabricating 410 also includes at least one of coupling and forming at least one second surface pad 134 to backside surface 108 of die 102. In other embodiments, not shown, at least one of device 132 and second surface pad 134 are at least one of formed on and coupled to backside surface 108 prior to at least one of first metallizing 402 and preparing 404, i.e., prior to packaging semiconductor chip 100, including at least one of before dicing, i.e., singulation, of the wafer into at least one die 102 and after dicing the wafer into at least one die 102. In still other embodiments, not shown, additional integrated circuit 138 is formed in backside surface 108 of die 102 at least one of during and prior to fabricating 410.

Also, in the exemplary embodiment, fabricating 410 further includes at least one of forming and coupling at least one extension 136 on and to, respectively, at least one of device 132, die 102, second surface pad 134, and additional integrated circuit 138 (if present). In other embodiments, not shown, at least one of forming and coupling extension 136 on and to, respectively, at least one of device 132, die 102, second surface pad 134, and additional integrated circuit 138 occurs prior to at least one of fabricating 410 and positioning 408 including, without limitation, one of prior to wafer dicing and after wafer dicing. Further, during fabricating 410, extension 136 is further at least one of formed and coupled on and to, respectively, at least one of core dielectric layer 109, conductive core 118, and interconnect 128, additional dies 102, and any other suitable devices, components, interfaces, layers, and materials, not shown in FIG. 4. Furthermore, in the exemplary embodiment, manufacturing processes used during fabricating 410 for at least one of forming and coupling at least one of device 132 and extension 136 include, without limitation, at least one of additive processes (e.g., three-dimensional (3D) printing, including laser printing), deposition processes, patterning processes, and other fabrication processes, and such processes may be employed both during and prior to fabricating 410 step.

Further, in the exemplary embodiment, sequence 400 proceeds from fabricating 410 to a placing 412 step. Placing 412 includes positioning a second adhesive layer 120 upon one side of second dielectric layer 116. In other embodiments, not shown, placing 412 includes positioning second adhesive layer 120 upon second side 111 of core dielectric layer 109 and backside surface 108 of die 102, rather than positioning second adhesive layer 120 upon one side of second dielectric layer 116. Placing 412 also includes placement of the side of second dielectric layer 116 having second adhesive layer 120 onto second side 111 of core dielectric layer 109 to couple second side 111 and backside surface 108 to second dielectric layer 116. In other embodiments, not shown, placing 412 includes placement of second dielectric layer 116 into second adhesive layer 120 on second side 111. In still other embodiments, not shown, placing 412 also includes defining an aperture through second dielectric layer 116 and coupling additional devices 132 upon backside surface 108 of die 102 using substantially similar described above with reference to fabricating 410 step.

Furthermore, in the exemplary embodiment, placing 412 thus results in a stack 413 of substantially aligned planes defined by first dielectric layer 114, core dielectric layer 109, and second dielectric layer 116. Stack 413 includes a first outer surface 414 defined on a side of first dielectric layer 114 distal core dielectric layer 109. Stack 413 also includes a second outer surface 415 defined on a side of second dielectric layer 116 distal core dielectric layer 109. In other embodiments, not shown, semiconductor chip package 100 does not include at least one of core dielectric layer 109 and second dielectric layer 116, and consequently, sequence 400 does not include placing 412.

Moreover, in the exemplary embodiment, sequence 400 proceeds from placing 412 to a curing 416 step. Curing 416 includes at least one of physical treatments (e.g., heating), chemical treatments (e.g., vapor exposure), and mechanical treatments (e.g., pressing) to facilitate a flow of adhesive in first and second adhesive layers 120 into voids between first dielectric layer 114, core dielectric layer 109, second dielectric layer 116, aperture 112, and die 102. Curing 416 also includes hardening first and second adhesive layers 120 to cause a strong and secure coupling and adhesive bond between first dielectric layer 114, core dielectric layer 109, second dielectric layer 116, aperture 112, and die 102. Curing 416 thus facilitates structural integrity of semiconductor chip package 100 and protection of device 132, extension 136, integrated circuit 106, additional integrated circuit 138 (if present), and other components and devices of semiconductor chip package 100.

Also, in the exemplary embodiment, sequence 400 proceeds from curing 416 to a drilling 418 step. Drilling 418 includes defining substantially cylindrical cavities, i.e., voids, in at least one of first dielectric layer 114, second dielectric layer 116, and adhesive layer 120, thus forming at least one additional via 122 therethrough. Further, in the exemplary embodiment, manufacturing processes used during drilling 418 include, without limitation, at least one of laser processes, dissolving processes, cutting processes, and other fabrication processes, and such processes may be employed during, prior to, or after drilling 418 step. Furthermore, in the exemplary embodiment, at least one additional via 122 is defined through at least one of first dielectric layer 114, second dielectric layer 116, and adhesive layer 120 to provide access from at least one of first outer surface 414 and second outer surface 415 to at least one of conductive core 118, first surface pad 130, integrated circuit 106, at least one via 122 formed through core dielectric layer 109, second surface pad 134, extension 136, device 132, additional integrated circuit 138, and other devices and components of semiconductor chip package 100 positioned between first dielectric layer 114 and second dielectric layer 116. In other embodiments, not shown, semiconductor chip package 100 does not include via 122, and consequently, sequence 400 does not include drilling 418.

Furthermore, in the exemplary embodiment, sequence 400 proceeds from drilling 418 to a second metallizing 420 step. Second metallizing 420 includes positioning, including coupling, first metallized layer 124 to first outer surface 414 of first dielectric layer 114. Second metallizing 420 also includes positioning, including coupling, second metallized layer 126 to second outer surface 415 of second dielectric layer 116. Moreover, in the exemplary embodiment, second metallizing 420 includes removing by processes including, without limitation, at least one of etching, masking, cutting, dissolving, and heating, at least a portion of at least one of first metallized layer 124 and second metallized layer 126 to create patterns of at least one of electrical power lines and communication lines therein. Second metallizing 420 further includes filling at least one additional via 122 with at least one of a conductive material and a non-conductive material (as described above with reference to FIG. 1) to form at least one interconnect 128. Second metallizing 420 thus facilitates at least one of electrically coupling and communicatively coupling at least one of first metallized layer 124 and second metallized layer 126 to at least one of conductive core 118, first surface pad 130, integrated circuit 106, at least one via 122 formed through core dielectric layer 109, second surface pad 134, extension 136, device 132, additional integrated circuit 138, and other devices and components of semiconductor chip package 100 positioned between first dielectric layer 114 and second dielectric layer 116. In other embodiments, not shown, at least one via 122 is not filled with at least one of a conductive material and a non-conductive material, but rather, at least one via 122 is not filled and is left unfilled as a cavity, e.g., a through-hole, through at least one of core dielectric layer 109, first dielectric layer 114, second dielectric layer 116, and adhesive layer 120. In still other embodiments, not shown, semiconductor chip package 100 does not include at least one of core dielectric layer 109 and second dielectric layer 116, and consequently, sequence 400 does not include second metallizing 420.

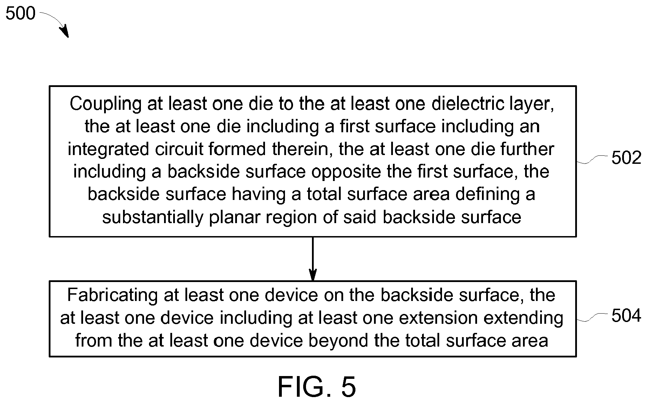

FIG. 5 is a flowchart of an exemplary method 500 of manufacturing a semiconductor chip package that may be used to manufacture semiconductor chip package 100 shown in FIG. 1. In an exemplary embodiment, method 500 includes coupling 502 at least one die 102 to at least one dielectric layer (e.g., first dielectric layer 114, used as a substrate for manufacturing semiconductor chip package 100). As shown and described above with reference to FIGs. 2 and 4, prior to coupling 502, die 102 includes at least one integrated circuit 106 fabricated in first surface 104 (e.g., after singulation of die 102 from a wafer). Also, in an exemplary embodiment, method 500 includes fabricating 504 at least one device 132 on backside surface 108. Fabricating 504 includes extending at least one extension 136 coupled to the at least one device 132 such that extension 136 extends from device 132 beyond total surface area 206 of backside surface 108. Further, in the exemplary embodiment, coupling 502 and fabricating 504 are substantially fully completed prior to connecting (i.e., by at least one of electrically coupling and communicatively coupling including, without limitation, through at least one of via 122 and interconnect 128) at least one of device 132 and extension 136 to at least one of first surface pad 130, second surface pad 134, first metallized layer 124, second metallized layer 126, core dielectric layer 109, first dielectric layer 114, second dielectric layer 116, conductive core 118, integrated circuit 106, additional integrated circuit 138, at least one additional die 102 in a semiconductor chip package 100 including a plurality of dies 102, and at least one additional semiconductor chip package 100 of a system including a plurality of semiconductor chip packages 100 (e.g., connections made in sequence 400 during at least one of placing 412, curing 416, drilling 418, and second metallizing 420 steps).

In other embodiments, as shown and described above with reference to FIGs. 1-4, method 500 also includes forming an additional integrated circuit 138 in backside surface 108 in at least one of first surface area 202 and second surface area 204, where backside surface 108 has first surface area 202 and second surface area 204, and where first surface area 202 and second surface area 204 sum to total surface area 206. In still other embodiments, as shown and described above with reference to FIGs. 1-4, fabricating 504 also includes forming at least one device 132 on at least one of first surface area 202 and second surface area 204. In yet other embodiments, as shown and described above with reference to FIGs. 1-4, method 500 further includes electrically coupling at least one device 132 to at least one of integrated circuit 106 and another semiconductor chip package 100 of a plurality of semiconductor chip packages 100. In still other embodiments, as shown and described above with reference to FIGs. 1-4, method 500 also includes communicatively coupling at least one device 132 to integrated circuit 106 and another semiconductor chip package 100 of a plurality of semiconductor chip packages 100. In yet other embodiments, as shown and described above with reference to FIGs. 1-4, method 500 also includes coupling the at least one device 132 to at least one of core dielectric layer 109, first dielectric layer 114, second dielectric layer 116, first metallized layer 124, second metallized layer 126, and at least one interconnect 128 of a plurality of interconnects 128.

In other embodiments, as shown and described above with reference to FIGs. 1-4, at least one die 102 further includes a plurality of dies 102 including a first die 102 and a second die 102. In such other embodiments where coupling 502 includes coupling first die 102 and second die 102 to at least one of core dielectric layer 109, first metallized layer 124, second metallized layer 126, first dielectric layer 114, and second dielectric layer 116, method 500 further includes at least one of electrically coupling first die 102 to second die 102, and communicatively coupling first die 102 to second die 102. In still other embodiments, as shown and described above with reference to FIGs. 1-4, first surface 104 defines a substantially planar region including first edge 304 defining the perimeter of first surface 104, where a boundary of total surface area 206 includes second edge 306 defining the perimeter of backside surface 108, where at least one die 102 further includes sidewall 308 extending between first edge 304 and second edge 306, and where fabricating 504 includes extending at least one extension 136 onto sidewall 308. In yet other embodiments where fabricating 504 includes extending at least one extension onto sidewall 308, fabricating 504 also includes fabricating at least one device 132 on sidewall 308, as shown and described above with reference to FIGs. 1-4.

The above-described semiconductor die backside devices and methods of fabrication thereof provide functionality to the backside surface of the die, either by themselves or in addition to an integrated circuit therein. The above-described embodiments also facilitate mitigating limitations on increasing functionality, performance, and miniaturization of microelectronics. The above-described embodiments are further suited to improving functionality, performance, and miniaturization of microelectronics at other than the wafer lever of semiconductor dies. The above-described semiconductor die backside devices and methods of fabrication thereof are also suited to reducing the size and increasing the functionality per unit volume of semiconductor chip packages with devices added to the backside surface of the die. The above-described embodiments are further suited to providing manufacturing methods for adding devices to die backside surfaces in semiconductor chip packages that otherwise are unable to be integrated at the die level.

An exemplary technical effect of the methods, systems, and apparatus described herein includes at least one of: (a) providing increased functionality to backside surfaces of semiconductor chip package dies; (b) mitigating limitations on increasing functionality, performance, and miniaturization of microelectronics at other than the semiconductor die wafer level; (c) reducing the size and increasing the functionality per unit volume of semiconductor chip packages with devices added to the backside surface of the die; and (d) providing manufacturing methods for adding devices to die backside surfaces in semiconductor chip packages that otherwise are unable to be integrated at the die level.

Exemplary embodiments of the above-described semiconductor die backside devices and methods of fabrication thereof are not limited to the specific embodiments described herein, but rather, components of the devices and systems, and/or steps of the methods may be utilized independently and separately from other components and/or steps described herein. For example, the methods, systems, and apparatus may also be used in combination with other systems requiring improvements in performance, reduction in size and/or weight, and enhancement of efficiency and versatility of manufacturing processes, and the associated methods are not limited to practice with only the systems and methods as described herein. Rather, the exemplary embodiments can be implemented and utilized in connection with many other applications, equipment, and systems that may benefit from using the above-described embodiments of the above-described semiconductor die backside devices and methods of fabrication thereof to improve the performance, reduce the size and/or weight, and enhance the efficiency and versatility of manufacturing processes for microelectronic systems and other related systems in various applications.

Although specific features of various embodiments of the disclosure maybe shown in some drawings and not in others, this is for convenience only. In accordance with the principles of the disclosure, any feature of a drawing may be referenced and/or claimed in combination with any feature of any other drawing.

This written description uses examples to disclose the embodiments, including the best mode, and also to enable any person skilled in the art to practice the embodiments, including making and using any devices or systems and performing any incorporated methods. The patentable scope of the disclosure is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A die (102) for a semiconductor chip package (100), said die comprising:
a first surface (104) comprising an integrated circuit (106) formed therein;
a backside surface (108) opposite said first surface, said backside surface having a total surface area (206) defining a substantially planar region (302) of said backside surface; and
at least one device (132) formed on said backside surface, said at least one device comprising at least one extension (136) extending from said at least one device beyond the total surface area.

2. The die (102) in accordance with Claim 1, wherein one of:
said at least one device (132) at least one of electrically coupled and communicatively coupled to said integrated circuit (106); and
said at least one device at least one of electrically isolated and communicatively isolated from said integrated circuit.

3. The die (102) in accordance with Claim 1 or 2, wherein said backside surface (108) comprises an additional integrated circuit (138) formed therein.

4. The die (102) in accordance with Claim 3, wherein said additional integrated circuit (138) is at least one of:
electrically coupled to at least one of said at least one device (132) and said integrated circuit (106); and
communicatively coupled to at least one of said at least one device and said integrated circuit.

5. The die (102) in accordance with Claim 3 or 4, wherein said backside surface (108) has a first surface area (202) and a second surface area (204), the first surface area and the second surface area summing to the total surface area (206), wherein said at least one device (132) is formed on the first surface area, and wherein said additional integrated circuit (138) is formed in the second surface area.

6. The die (102) in accordance with Claim 5, wherein said at least one device (132) is formed on both the first surface area (202) and the second surface area (204), and wherein said additional integrated circuit (138) is formed in both the first surface area and the second surface area.

7. The die (102) in accordance with any preceding Claim, wherein said at least one device (132) comprises at least one of a sensor (132), an active circuit element (132), a passive circuit element (132), and a radio-frequency identification (RFID) element (132).

8. The die (102) in accordance with any preceding Claim, wherein said first surface (104) defines a substantially planar region (301) comprising a first edge (304) defining a perimeter of said first surface, wherein a boundary of the total surface area (206) comprises a second edge (306) defining a perimeter of said backside surface (108), said die further comprising a sidewall (308) extending between said first edge and said second edge, wherein said at least one extension (136) further extends onto said sidewall.

9. The die (102) in accordance with any preceding Claim, wherein said at least one device (132) is further formed on said sidewall (308).

10. The die (102) in accordance with any preceding Claim, further comprising a plurality of devices (132) comprising a first device (132) and a second device (132), wherein each of said first device and said second device comprises said at least one device (132), and wherein said first device is at least one of electrically coupled and communicatively coupled to said second device.

11. A semiconductor chip package (100) comprising:
at least one dielectric layer (109,114,116);
at least one metallized layer (124,126) coupled to said at least one dielectric layer; and
at least one die (102) coupled to at least one of said at least one dielectric layer and said at least one metallized layer, said at least one die as recited in any preceding Claim.

12. The semiconductor chip package (100) in accordance with Claim 11 further comprising at least one of at least one interconnect (128) and at least one via (122), said at least one via defined as a cavity (122) through at least one of said at least one metallized layer (124,126) and said at least one dielectric layer (124,126), said at least one interconnect coupled to said at least one metallized layer and extending through said at least one via to further couple said at least one metallized layer to at least one of said at least one device (132) and said integrated circuit (106), wherein said at least one device is further coupled to at least one of said at least one dielectric layer and said at least one interconnect.

13. The semiconductor chip package (100) in accordance with Claim 11 further comprising a plurality of dies (102) comprising a first die (102) and a second die (102), wherein each of said first die and said second die comprises said at least one die (102), and wherein said first die is one of:
at least one of electrically coupled and communicatively coupled to said second die; and
at least one of electrically isolated and communicatively isolated from said second die.

14. A method of manufacturing a semiconductor chip package (100), the semiconductor chip package (100) including at least one dielectric layer (109,114,116), said method comprising:
coupling at least one die (102) to the at least one dielectric layer (109,114,116), the at least one die (102) including a first surface (104) including an integrated circuit (106) formed therein, the at least one die (102) further including a backside surface (108) opposite the first surface (104), the backside surface (108) having a total surface area (206) defining a substantially planar region (302) of said backside surface (108); and
fabricating at least one device (132) on the backside surface (108), the at least one device (132) including at least one extension (136) extending from the at least one device (132) beyond the total surface area (206).

15. The method in accordance with Claim 14, wherein fabricating at least one device (132) upon the backside surface (108) comprises coupling the at least one device (132) to the backside surface (108) using a process comprising at least one of an additive process, a deposition process, and a patterning processing.
